(19) Europäisches Patentamt
European Patent Office
Office européen des brevets

(11) Veröffentlichungsnummer: **0 000 702**
**B1**

(12) # EUROPÄISCHE PATENTSCHRIFT

(45) Veröffentlichungstag der Patentschrift: **07.10.81**

(51) Int. Cl.³: **G 03 F 7/26** // H01L21/312

(21) Anmeldenummer: **78100337.1**

(22) Anmeldetag: **10.07.78**

(54) **Verfahren zur Herstellung einer fliessbeständigen Resistmaske aus strahlungsempfindlichem Resistmaterial.**

(30) Priorität: **08.08.77 US 822468**

(43) Veröffentlichungstag der Anmeldung: **21.02.79 Patentblatt 79/4**

(45) Bekanntmachung des Hinweises auf die Patenterteilung: **07.10.81 Patentblatt 81/40**

(84) Benannte Vertragsstaaten: **DE FR GB**

(56) Entgegenhaltungen:
**IBM TECHNICAL DISCLOSURE BULLETIN, Band 18, Nr. 5, Oktober 1975, Armonk, New York, B. BERGIN et al.: "Single layer optical lift-off process"**

**CHEMICAL ABSTRACTS, Band 82, 1975, Colombus, Ohio (USA) A.I. PARAMONOV et al.: "Positive photoresist", Seite 486**

(73) Patentinhaber: **International Business Machines Corporation, Armonk, N.Y. 10504 (US)**

(72) Erfinder: **Chiu, George Tein-Chu, 48 Brandy Lane, Wappingers Falls NY 13590 (US)**
Erfinder: **Fredericks, Edward Carmine, Frances Drive Box 215, Hopewell Junction NY 12533 (US)**

(74) Vertreter: **Kreidler, Eva-Maria, Dr. rer. nat., Schönaicher Strasse 220, D-7030 Böblingen (DE)**

**EP 0 000 702 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

# Verfahren zur Herstellung einer fliessbeständigen Resistmaske aus strahlungsempfindlichem Resistmaterial

Die Erfindung betrifft ein Verfahren zur Herstellung einer fliessbeständigen Maske aus strahlungsempfindlichem Resistmaterial.

Die Ausbildung von Resistmasken bei der Herstellung integrierter Schaltkreise unter Verwendung strahlungsempfindlicher Schichten mit einem Gehalt an verschiedenen organischen Polymeren ist bekannt. Schichten aus einem strahlungsempfindlichen Material werden auf eine Unterlage aufgetragen, Licht oder einer anderen aktivierenden Strahlung wie Elektronenstrahlen oder Röntgenstrahlen in einem bildmässigen Muster ausgesetzt und zu einem sichtbaren Bild entwickelt durch Entfernen der löslicheren Anteile der Schicht in einer Entwicklerlösung. Um die Eigenschaften der zurückbleibenden Teile der Resistschicht zu verbessern, beispielsweise der Adhäsion zu verschiedenen Unterlagen, ihre Widerstandsfähigkeit gegen chemischen und/oder thermischen Abbau, wird das Resistmuster in üblicher Weise bei einer erhöhten Temperatur nachgehärtet. Die thermoplastischen Polymermaterialien in dem Resist fliessen bei Temperaturen, die über deren Glasübergangstemperatur liegen. Diese Tendenz zum Fliessen deformiert das Resistbildmuster, und bei den hochaufgelösten Mustern, welche beispielsweise zur Herstellung integrierter Schaltkreise erforderlich sind, kann diese Verformung zu Dimensionsänderungen oder sogar zum Zusammenfliessen der feinen Linien führen. Eine solche Verformung kann auch stattfinden, wenn das Resistbild während eines Prozesschritts, durchgeführt am Substrat, erhitzt wird, beispielsweise bei Anwendung heisser Ätzlösungen, Ionenimplantation oder Plasmaätzen. Um diesen Nachteil zu beseitigen, wurden dem Photoresist freie Radikalbildner einverleibt, wie beispielsweise in der deutschen Offenlegungsschrift 2 518 480 beschrieben ist. Mit diesem Verfahren werden zwar Resistmasken mit verbesserter chemischer und thermischer Beständigkeit erhalten, gleichzeitig wird jedoch auch die Strahlungsempfindlichkeit der Resistmaterialien herabgesetzt, so dass längere Belichtungszeiten erforderlich sind. In der US-Patentschrift 3 920 483 wird ein Resisthärtungsprozess zur Anwendung vor der Ionenimplantation beschrieben, bei dem die Resistmaske einer Hochfrequenz-Gasplasmaoxidation unterworfen wird, um die Dicke der Photoresistschicht herabzusetzen und das Fliessen des Resists während der Ionenimplantation zu begrenzen.

Aufgabe der Erfindung ist ein Verfahren zur Herstellung einer fliessbeständigen Maske aus strahlungsempfindlichem Resistmaterial durch Härten, bei dem keine besondere Einrichtung für den Härtungsprozess erforderlich ist und bei dem die Resistzusammensetzung vor der Belichtung nicht modifiziert zu werden braucht.

Die Aufgabe der Erfindung wird gelöst durch ein Verfahren der eingangs genannten Art, das dadurch gekennzeichnet ist, dass auf die Maske ein Härtungsmittel vom o-Chinondiazidtyp aufgetragen, die beschichtete Maske erhitzt und dann das überschüssige Härtungsmittel entfernt wird.

Vorteilhafte Ausführungsformen der Erfindung sind in den Unteransprüchen niedergelegt.

Die Härtungsmittel zur Anwendung in dem erfindungsgemässen Verfahren sind wasserlösliche Salze der o-Chinondiazidsulfon- und Carbonsäuren. Verbindungen dieser Art schliessen o-Chinondiazide der Benzol-, Naphthalin- und Phenanthren-Reihe ein. Beispiele der Verbindungen haben die nachfolgend angegebenen Formeln:

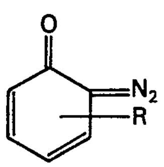
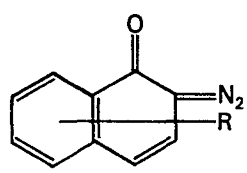
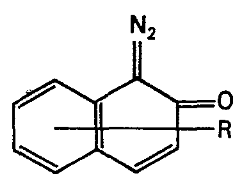

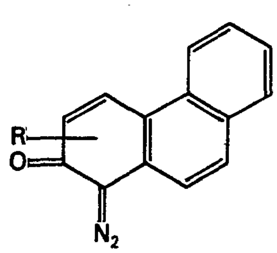

in denen R $SO_3X$ oder COOX und X beispielsweise $Na^+$, $K^+$, $Ca^{2+}$, $Ba^{2+}$, $Li^+$ oder $NH_4^+$ ist.

Beispiele spezieller Verbindungen sind:

Das Natriumsalz der Benzol-2,1-diazo-oxid-4-sulfonsäure, das Natriumsalz der Naphthalin-1,2-diazo-oxid-4-sulfonsäure, das Kaliumsalz der Naphthalin-1,2-diazo-oxid-4-carbonsäure, das Natriumsalz der Naphthalin-2,1-diazo-oxid-5-sulfonsäure, das Natriumsalz der 1,2-Diazo-phenanthrol-(2)-x-sulfonsäure.

Die Beschichtungslösungen der Härtungsmittel werden in solchen Konzentrationen hergestellt, dass etwa 0,5 bis 10 Gew.-% des Härtungsmittels, bezogen auf das Gesamtgewicht der Lösung vorhanden ist. Konzentrationen unter 0,5 Gew.-% bewirken unter Umständen eine nicht ausreichende Härtung zur Verhinderung des Resistfliessens beim Erhitzen. Es werden auch keine besonderen Vorteile erhalten bei Anwendung von Mengen, die grösser als 10 Gew.-% sind, und die Anwesenheit solcher Mengen kann zu Krater- oder Blasenbildung, verursacht durch die Gasentwicklung während des Erhitzens, in dem Resistmaskenmuster führen.

In der Praxis sollten die Konzentrationen, wenn Resistschichtflächen ohne Muster grösser als 0,508×0,508 mm vorhanden sind, in einem Bereich von etwa 0,5 bis 1,5 Gew.-% gehalten werden, um die Kraterbildung in diesen durchgehenden Bereichen zu vermeiden.

Das Lösungsmittelsystem oder das Härtungsmittel ist auf wässriger Basis, damit ein Angriff der Resistschicht durch die Beschichtungslösung vermieden wird. Es wurde gefunden, dass die Resistschicht durch die Beschichtungslösung besser benetzt wird und demzufolge ein einheitlicherer Überzug des Härtungsmittels erhalten wird, wenn eine Mischung von Wasser mit Alkoholen mit 2 bis 4 Kohlenstoffatomen, beispielsweise mit Äthanol, Propanol oder Butanol verwendet wird. Die Anteile von Wasser und Alkohol werden so gewählt, dass eine ausreichende Löslichkeit des Härtungsmittels erhalten und gleichzeitig ein Angriff des Lösungsmittels auf das Resistsystem vermieden wird. Anstelle oder zusätzlich zu den Alkoholen können zur Verbesserung der Benetzung oberflächenaktive Mittel in Mengen von etwa 0,01 bis 1 Gew.-% zugesetzt werden. Beispiele brauchbarer oberflächenaktiver Mittel sind Natriumlaurylsulfat, oberflächenaktive Mittel auf Fluorkohlenwasserstoffbasis, Natriumpalmitat und Polymethacrylsäurelösungen.

Das Härtungsmittel wird auf die Resistmaske mittels konventioneller Verfahren, beispielsweise durch Tauchen, Sprühen oder Verspinnen aufgetragen unter Erhalt einer kontinuierlichen Schicht über der Resistmaske und der Unterlage. Eine Schichtdecke von etwa 40 nm ist als Minimum erforderlich, um einen kontinuierlichen Überzug auf der Oberfläche und den Seitenwänden des Resistbildes zu erhalten. Eine Schichtdicke von etwa 50 bis 100 nm wird bevorzugt. Die gewünschte Schichtdicke kann bei der Technik des Verspinnens durch Variation der Spinngeschwindigkeit erhalten werden. Die Spinnzeit wird so gewählt, dass ein Grossteil des Lösungsmittels durch Verdampfen entfernt wird.

Die Resistzusammensetzungen, welche mit dem erfindungsgemässen Verfahren gehärtet werden können, können entweder positiv oder negativ arbeitende Resistmaterialien sein. Negative Resistmaterialien sind solche, die, wenn sie bestrahlt werden, vernetzen und weniger löslich werden. Beispiele negativer Resistmaterialien sind sensibilisierte Polyvinylcinnamat-Polymerzusammensetzungen, die beispielsweise in der US-Patentschrift 2 732 301 beschrieben sind und sensibilisierte, teilcyclisierte Poly-cis-isopren-Polymerzusammensetzungen, die beispielsweise in der US-Patentschrift 2 852 379 beschrieben sind. Beispiele positiver Resistmaterialien, welche unter Einwirkung von Strahlung abgebaut und dadurch mehr löslich werden, sind sensibilisierte Novolakharzzusammensetzungen, die beispielsweise in den US-Patentschriften 3 046 118, 3 046 121, 3 201 239 und 3 666 743 beschrieben sind.

Die Resistschichten werden auf eine Unterlage aufgetragen und bildmässig belichtet. Anschliessend werden die löslicheren Bereiche der Schicht, die im Falle eines positiven Resists die belichteten Bereiche und im Falle eines negativen Resists die nichtbelichteten Bereiche sind, mit einer Entwicklerlösung entfernt. Das resultierende Resistmaskenmuster kann dann in dem erfindungsgemässen Verfahren behandelt werden, indem es mit einer Schicht eines o-Chinondiazid-Härtungsmittels bedeckt wird. Nach dem Beschichten wird die Resistmaske auf eine Temperatur erhitzt, die ausreichend ist, um eine Reaktion des o-Chinondiazids mit der Resistschicht herbeizuführen unter Ausbildung einer vernetzten äusseren Schicht, insbesondere an den Seitenwänden des Resistbildes, so dass das seitliche Fliessen des Bildes verhindert wird, wenn das Bild auf Temperaturen erhitzt wird, die über den Glasübergangstemperaturen des Polymeranteils der Resistschicht liegen. Es werden Temperaturen in einem Bereich von etwa 110 bis 210°C und eine inerte Atmosphäre, beispielsweise Stickstoffatmosphäre angewendet. Eine Härtung in einem Ofen wird bevorzugt, weil weniger Krater in relativ grossen Resistschichtbereichen ohne Muster ausgebildet werden im Vergleich zur Härtung der Resistschicht auf einer Heizplatte. Härtungszeiten von 10 bis etwa 30 Minuten sind ausreichend, um die Härtung zu Ende zu führen.

Nachdem die Härtung zu Ende geführt wurde, kann der Rückstand des Härtungsmittels, welches auf der Unterlage an den Rändern der Resistmaske zurückbleibt, durch Spülen mit Wasser leicht entfernt werden. Die resultierende Resistmaske zeigt kaum seitliches Fliessen der Bilder. Das gehärtete Resistbild behält seine Dimensionen bei nachfolgenden Behandlungen der freigelegten Bereiche der Unterlage, beispielsweise beim Ätzen mit heissen Säuren oder mit einem reaktiven Gasplasma, bei der Ionenimplantation oder einem Metallaufdampfverfahren, bei denen die Resistschicht auf höhere Temperaturen erhitzt wird.

Die Erfindung wird anhand der nachfolgenden Ausführungsbeispiele näher erläutert.

Beispiel 1

Ein Maskenmuster aus einem positiven Photoresist wurde auf der Oberfläche eines gereinigten, mit Metall beschichteten Siliciumhalbleiterwafers ausgebildet. Die Resistzusammensetzung bestand aus einem Phenolformaldehyd-Novolakharz und dem 2-Diazo-1-oxo-naphthalin-5-sulfonsäureester des Dihydroxybenzophenons. Der

Resist wurde durch Verspinnen bei 4000 Umdrehungen pro Minute auf die Metalloberfläche aufgetragen, zu einer Trockenschichtdicke von etwa 2,2 µm 20 Minuten lang bei etwa 85°C gehärtet und dann bildmässig mit aktinischer Strahlung belichtet und mit einer wässrigen alkalischen Entwicklerlösung entwickelt, um die belichteten Bereiche zu entfernen. Auf die Resistmaske und den Wafer wurde durch Verspinnen bei 3000 Umdrehungen pro Minute innerhalb einer Minute eine 1 Gew.-%ige Lösung des Natriumsalzes der 2-Diazo-1-oxid-naphthalin-5-sulfonsäure in einer Mischung aus Wasser und Isopropanol im Volumenverhältnis 50:50 aufgetragen. Die Beschichtungsdicke betrug etwa 50 nm. Der beschichtete Wafer wurde dann in einem Ofen unter Stickstoff 20 Minuten lang bei einer Temperatur von 210°C ± 5°C gehärtet, und dann wurde der Rückstand des Härtungsmittels durch ein 5 Minuten dauerndes Spülen mit deionisiertem Wasser entfernt. Das Härtungsmittel verhinderte ein seitliches Fliessen der Resistbilder, und die Dimensionsänderungen der Bilder waren klein ($\leq$ 0,508 µm).

Die freigelegten Bereiche der Metallschicht wurden dann geätzt, indem der Wafer in ein reaktives Gasplasma gegeben wurde. Die Abtragung der Resistmaske war einheitlich, und der Resist wies nach dem Metallätzverfahren eine glatte Oberfläche auf. Durch dieses Verfahren wird die Anwendung einer dünneren Resistmaske möglich, ohne dass ein Angriff auf die unter der Maske liegenden Teile der Metallschicht während des Plasmaätzprozesses stattfindet. Im Gegensatz dazu zeigten Resistschichten auf Vergleichswafern, die nur in üblicher Weise nachgehärtet waren oder einen Peroxidzusatz in der Zusammensetzung enthielten, nach dem Plasmaätzen eine rauhe Oberfläche mit Löchern.

Die Anwendung des Härtungsmittels in Konzentrationen im Bereich von 2,5 bis 5 Gew.-% gemäss Beispiel 1 führte zu einer normalen Härtung des Photoresistmusters, aber grosse, 0,508×1,27 mm Resistbereiche ohne Muster zeigten Krater, welche offensichtlich durch das Bersten eingeschlossener Gasblasen verursacht wurden, die während des Härtungsverfahrens gebildet worden waren. Bei Anwendung einer Härtungsmittelkonzentration von 0,25 Gew.-%, bei der nur kleine Änderungen in der Bildgrösse verursacht wurden, zeigte sich eine beachtliche Verdünnung der schmalen (etwa 2,54 µm) Resistlinien. Die optimale Härtungsmittelkonzentration sollte deshalb so gewählt werden, dass das Fliessen auf ein Minimum herabgesetzt wird und gleichzeitig eine Kraterbildung in dem speziellen zu behandelnden Resistmuster vermieden wird. Konzentrationen von etwa 0,5 bis 1,25 Gew.-% ergaben gute Gesamtergebnisse für integrierte Schaltkreismuster.

Beispiel 2

Ein Maskenmuster aus einem positiven Photoresist mit einer Dicke von etwa 1,5 µm wurde, wie in Beispiel 1 angegeben, auf einem Siliciumwafer, dessen Oberfläche mit einem thermischen Oxid beschichtet war, ausgebildet. Die Resistmaske wurde beschichtet unter Verwendung einer Lösung des Natriumsalzes der 1-Diazo-2-oxid-naphthalin-4-sulfonsäure in deionisiertem Wasser. Ungefähr 4 bis 6 ml der Lösung, welche durch ein 0,5 µm Filter filtriert war, wurde innerhalb 1 Minute auf die Resistbilder mit einer Spinngeschwindigkeit von 3500 Umdrehungen pro Minute aufgesponnen. Der Wafer wurde dann in einem Ofen unter Stickstoffatmosphäre 20 Minuten lang bei einer Temperatur von 210°C ± 5°C gehärtet. Mikrophotographien des Resistbildes zeigten, dass ein Fliessen des Resistbildes im wesentlichen vermieden wurde. Im Gegensatz dazu zeigten Resistbilder auf Kontrollwafern, welche dem erfindungsgemässen Härtungsverfahren nicht unterworfen worden waren, ein starkes Fliessen nach einem Härten bei 210°C. Resistbilder, welche mit Peroxiden wie Lupersol 101 (2,5-Dimethyl-2,5-di(tert-butyl-peroxy)-hexan oder Polymethacrylsäurelösungen in deionisiertem Wasser behandelt und 20 Minuten bei 210°C nachgehärtet worden waren, zeigten auch starkes Fliesen und waren deformiert.

Beispiel 3

Um die Anwendung des erfindungsgemässen Verfahrens auf negativ arbeitende Resistmaterialien zu zeigen, wurden Siliciumhalbleiterwafer, deren Oberfläche mit einem thermischen Oxid bedeckt war, mittels Verspinnen bei 6000 Umdrehungen pro Minute mit einer Resistschicht beschichtet, welche aus einem teilweise cyclisierten Poly-cis-isoprenpolymeren und 2,6-Bis-(p-azido-benzyliden)-4-methylcyclohexan als Sensibilisator bestand. Die Schicht wurde 20 Minuten lang bei 90°C vorgehärtet und dann 1 Minute lang mit ultraviolettem Licht bildweise belichtet. Die belichteten Wafer wurden 4 Minuten lang bei Zimmertemperatur in einem Lösungsmittel entwickelt, um die nichtbelichteten Bereiche zu entfernen und mit Stickstoff trockengeblasen. Der Wafer wurde dann in zwei Hälften geteilt, und eine Hälfte wurde mit einer wässrigen Lösung mit einem Gehalt an 4,3 Gew.-% des Natriumsalzes der 2-Diazo-1-oxid-naphthalin-5-sulfonsäure und 0,1 Gew.-% Polymethacrylsäure beschichtet. Die andere Hälfte wurde zur Kontrollmessung verwendet. Beide Waferhälften wurden 30 Minuten in einer Stickstoffatmosphäre in einem Ofen bei 180°C gehärtet. Das behandelte Resistbild zeigte nach der Härtung eine wesentliche verbesserte Dimensionsstabilität des Bildes. Das Resistbild auf der nichtbehandelten Hälfte war stark zerflossen. Ähnliche Ergebnisse wurden mit einem anderen Wafer erhalten, dessen eine Hälfte behandelt und die andere Hälfte nicht behandelt war und beide Hälften 30 Minuten lang unter Stickstoff bei 210°C gehärtet worden waren.

Es wurde ein Härtungsverfahren für Resistmasken beschrieben, für welches keine besonderen Apparaturen oder Zusätze zu der Resistschicht vor Ausbildung der Resistmaske erforderlich sind.

**Patentansprüche**

1. Verfahren zur Herstellung einer fliessbeständigen Maske aus strahlungsempfindlichem Resistmaterial auf einer Unterlage, dadurch gekennzeichnet, dass auf die Maske ein Härtungsmittel vom o-Chinondiazidtyp aufgetragen, die beschichtete Maske erhitzt und dann das überschüssige Härtungsmittel entfernt wird.

2. Verfahren nach Anspruch 1, dadurch gekennzeichnet, dass als Härtungsmittel wasserlösliche Salze von o-Chinondiazidsulfonsäuren oder Carbonsäuren aufgetragen werden.

3. Verfahren nach den Ansprüchen 1 und 2, dadurch gekennzeichnet, dass als Härtungsmittel o-Chinondiazid-Verbindungen der allgemeinen Formeln

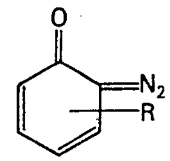
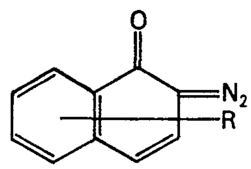
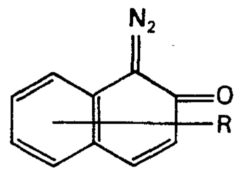
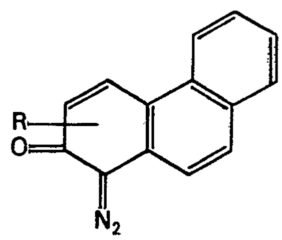

in denen R $SO_3X$ oder COOX ist und X gewählt ist aus der Gruppe von $Na^+$, $K^+$, $Ca^{2+}$, $Ba^{2+}$, $Li^+$ oder $NH_4^+$, aufgetragen werden.

4. Verfahren nach den Ansprüchen 1 bis 3, dadurch gekennzeichnet, dass das Härtungsmittel in Form einer wässrigen oder wässrig-alkoholischen Lösung mit einem Gehalt an 0,5 bis 10 Gew.-% auf die Maske aufgetragen wird.

5. Verfahren nach einem oder mehreren der Ansprüche 1 bis 4, dadurch gekennzeichnet, dass das Härtungsmittel in einer Schichtdicke von 50 bis 100 nm auf die Maske aufgetragen wird.

6. Verfahren nach einem oder mehreren der Ansprüche 1 bis 5, dadurch gekennzeichnet, dass die beschichtete Maske auf eine Temperatur zwischen 110 und 210°C erhitzt wird.

7. Verfahren nach einem oder mehreren der Ansprüche 1 bis 6, dadurch gekennzeichnet, dass das Härtungsmittel auf eine Maske aus einem positiv arbeitenden oder einem negativ arbeitenden strahlungsempfindlichen Resistmaterial aufgetragen wird.

**Claims**

1. Method of making a flow resistant mask of radiation-sensitive resist material on a substrate, characterized in that a hardening agent of the orthoquinone diazide type is applied to the mask, that the coated mask is heated and the excess hardening agent is then removed.

2. Method as claimed in claim 1, characterized in that water soluble salts of orthoquinone diazide sulfonic acid or carbon acid are applied as hardening agents.

3. Method as claimed in claims 1 and 2, characterized in that as hardening agents orthoquinone diazide compounds of the general formulas

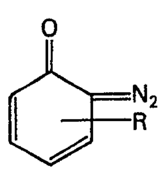
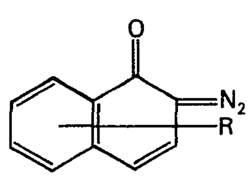
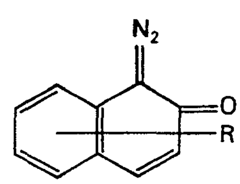
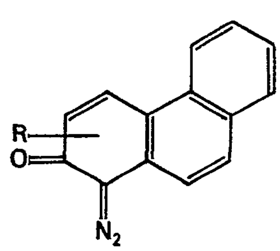

are applied where R is $SO_3X$ or COOX, and where X is selected from the group consisting of $Na^+$, $K^+$, $Ca^{2+}$, $Ba^{2+}$, $Li^+$ or $NH_4^+$.

4. Method as claimed in claims 1 to 3, characterized in that the hardening agent is applied to the mask in the form of an aqueous or aqueous-alcoholic solution with a content of 0.5 to 10 percent by weight.

5. Method as claimed in anyone or several of claims 1 to 4, characterized in that the hardening agent is applied to the mask in a layer thickness of 50 to 100 nm.

6. Method as claimed in anyone or several of claims 1 to 5, characterized in that the coated mask is heated to a temperature between 110 and 210°C.

7. Method as claimed in anyone or several of claims 1 to 6, characterized in that the hardening agent is applied to a mask of a positive acting or a negative acting, radiation-sensitive resist material.

**Revendications**

1. Procédé pour fabriquer un masque composé d'un matériau photo-résistant sensible à l'irradiation sur un support qui ne coule pas, caractérisé en ce que l'on dépose sur le masque un agent de durcissement du genre diazide d'ortho-quinone, et que l'on chauffe le masque ainsi recouvert, et que l'on enlève ensuite l'agent de durcissement en excés.

2. Procédé selon la revendication 1, caractérisé en ce que les agents de durcissement sont des sels, solubles dans l'eau, de diazides d'ortho-quinone de l'acide sulfonique ou de l'acide carbonique.

3. Procédé selon les revendications 1 et 2, caractérisé en ce que l'on applique comme agents de durcissement des composés du genre diazide d'ortho-quinone ayant les formules générales:

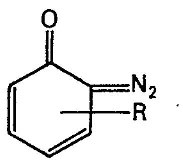

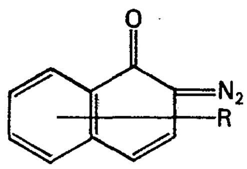

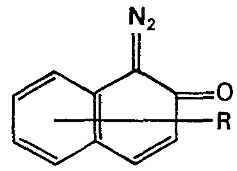

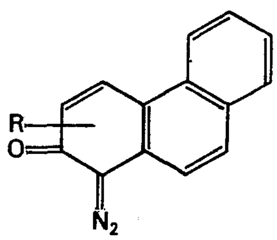

R étant du $SO_3X$ ou du COOX, et X étant pris dans le groupe comprenant $Na^+$, $K^+$, $Ca^{2+}$, $Ba^{2+}$, $Li^+$ ou $NH_4^+$.

4. Procédé selon l'une quelconque des revendications 1 à 3, caractérisé en ce que l'agent de durcissement est déposée sur le masque sous la forme d'une solution aqueuse ou aqueuse alcoolique dont il représente de 0,5 à 10% en poids.

5. Procédé selon l'une quelconque ou plusieurs des revendications 1 à 4, caractérisé en ce que l'épaisseur de la couche de l'agent de durcissement déposée sur le masque est comprise entre 50 et 100 nm.

6. Procédé selon l'une quelconque ou plusieurs des revendications 1 à 5, caractérisé en ce que le masque est chauffé à une température allant de 110 à 210°C.

7. Procédé selon l'une quelconque ou plusieurs des revendications 1 à 6, caractérisé en ce que l'agent de durcissement est déposé sur un masque constitué par un matériau photorésistant de type positif ou négatif sensible aux irradiation.